Europäisches Patentamt

European Patent Office

Office européen des brevets

(19)

(11) Publication number: **0 288 242 B1**

## EUROPEAN PATENT SPECIFICATION

(12)

(45) Date of publication of patent specification: **12.08.92**

(51) Int. Cl.⁵: **C30B 23/06**, C30B 25/10, H01L 21/31, H01L 21/324

(21) Application number: **88303510.7**

(22) Date of filing: **19.04.88**

(54) **A semiconductor crystal growth apparatus.**

(30) Priority: **21.04.87 JP 97959/87**
**27.04.87 JP 103699/87**

(43) Date of publication of application:
**26.10.88 Bulletin 88/43**

(45) Publication of the grant of the patent:
**12.08.92 Bulletin 92/33**

(84) Designated Contracting States:
**DE FR GB**

(56) References cited:
**EP-A- 0 196 897**

**PATENT ABSTRACTS OF JAPAN, vol. 11, no. 122 (E-500)[2569], 16th April 1987; & JP - A - 61 269 307 (HITACHI) 28-11-1986**

**"Semiconductor Research", Vol.21, No.5, pp101-116, published by Kogyo Chosakai , ( cited in application as filed originally; Japanese language )**

(73) Proprietor: **SEIKO INSTRUMENTS INC.**
**31-1, Kameido 6-chome Koto-ku**
**Tokyo 136(JP)**

(72) Inventor: **Aoki, Kenji**
**c/o Seiko Instrument Inc 31-1 Kameido**
**6-chome**
**Koto-ku Tokyo(JP)**

(74) Representative: **Miller, Joseph et al**
**J. MILLER & CO. 34 Bedford Row, Holborn**
**London WC1R 4JH(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to semi-conductor crystal growth apparatus for growing epitaxial layers on semi-conductor substrates.

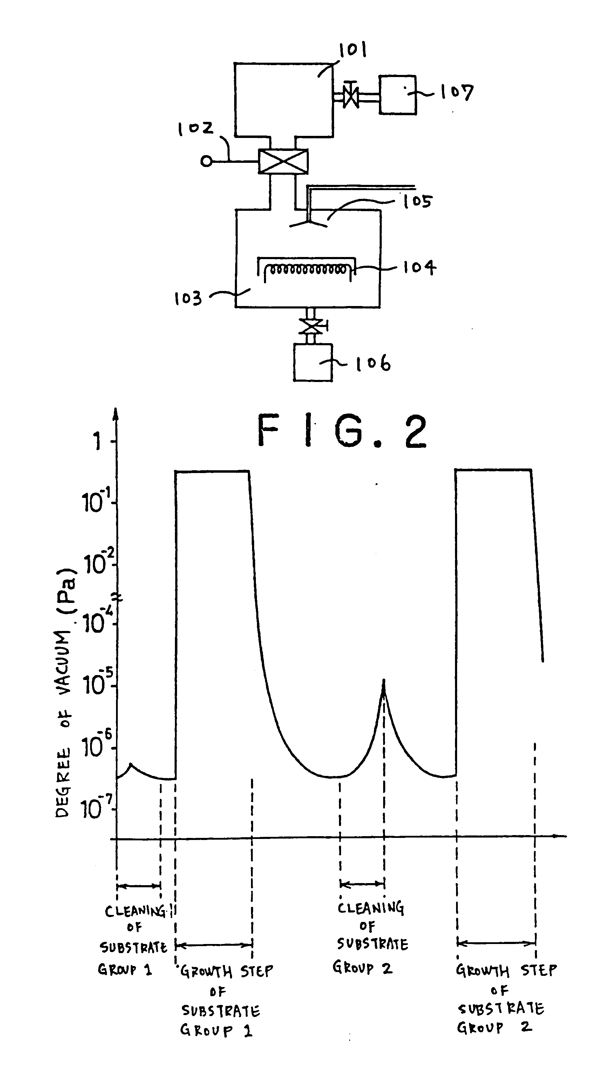

It is essential to clean the surface of a substrate in order to grow a high quality single crystal at low temperature thereon. To accomplish this objective, a method has been employed conventionally by which an oxide film for protecting the surface of a substrate from contamination is formed using a chemical cleaning method, and then the substrate is heated under ultra-high vacuum to remove the oxide film and to expose the cleaned surface. Cleaning of the surface used to be practiced using a vacuum vessel of a crystal growth apparatus such as shown in Figure 1. This crystal growth apparatus has a preparation chamber 101, a gate valve 102, evacuating units 106, 107, a gas introduction nozzles 105, a heater 104 for heating a substrate and a growth chamber 103.

In a mass production process wherein cleaning of the surface and crystal growth are repeated inside the same apparatus, the following problems occur if the surface cleaning step and the epitaxial crystal growth step are carried out inside the same vacuum vessel. Reaction products at the time of crystal growth attach to peripheral portions of a substrate heating system inside the vacuum vessel and its wall surface after the epitaxial growth step, but since the substrate temperature is generally higher at the time of surface cleaning than at the time of epitaxial growth, the reaction products that attach at the time of epitaxial growth are emitted once again as a gas due to thermal influences at the higher temperature at the next cleaning step of the substrate surface (see Figure 2). Consequently the background inside the vacuum vessel deteriorates. If a substrate surface is cleaned under such conditions, cleaning is not sufficient and the quality of crystals subsequently grown eventually falls. In order to avoid this problem in the conventional apparatus, after the crystal growth step, the vacuum vessel must be evacuated for a relatively long time while being baked, this being before carrying out the next surface cleaning step. Consequently, mass producibility of the apparatus drops.

An improved apparatus for forming an epitaxial growth layer on a substrate is disclosed in EP-A-0,196,897. The apparatus in this instance includes a substrate exchanging chamber, a pre-chamber for removing contamination, and a growth chamber. In use, a substrate passes from the exchanging chamber to the growth chamber by way of the pre-chamber so that its surface is prepared for the growth of an epitaxial layer when it enters the growth chamber.

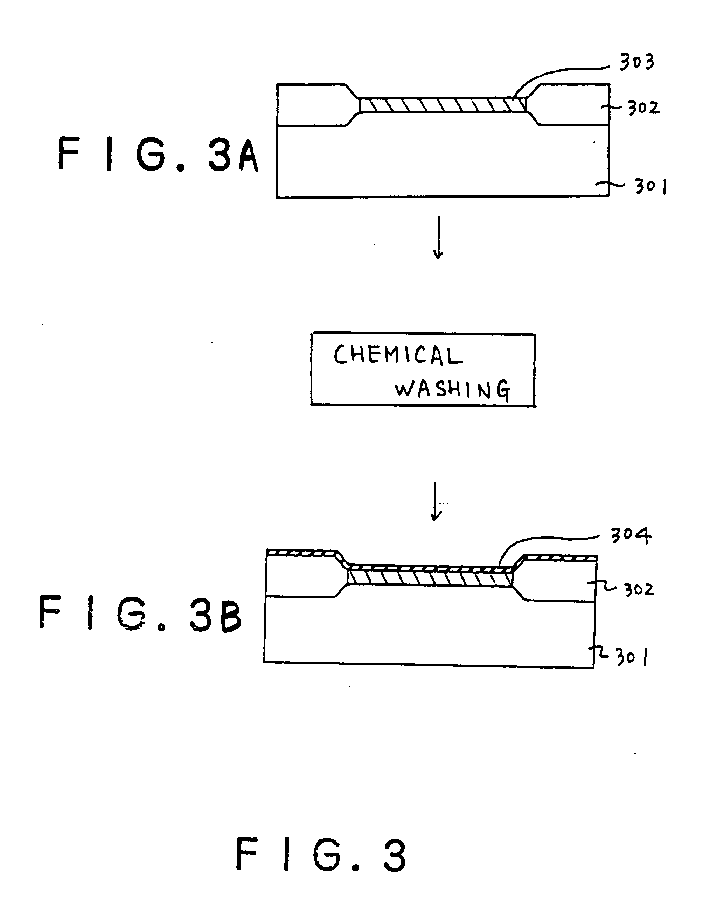

In the case of manufacturing an insulated gate field effect transistor (hereinafter called a "MOSFET") having an epitaxial growth layer in a growth chamber, a method of manufacturing a MOSFET as illustrated in Figures 3A and 3B has previously been employed. Figures 3A and 3B are sectional views showing the formation of steps of an epitaxial growth layer 303 and the gate oxide film 304 in a conventional MOSFET fabrication process. As shown in Figures 3A and 3B, the epitaxial growth layer 303 which forms a channel region, is formed on a substrate 301 by using a semi-conductor crystal growth apparatus having a growth chamber and then a gate oxide film 304 is formed on the epitaxial growth layer 303 by using a thermal oxidation furnace through a chemical washing step. In Figure 3 reference numeral 302 indicates a field oxide film.

Generally, it is of importance to improve the interface condition between the channel region and the gate oxide film of a MOSFET in order to improve MOSFET performance. In accordance with the conventional process, however, the formation of the channel region and the formation of the gate oxide film are carried out in entirely different chambers as described above, and moreover chemical washing is conducted before the formation of the gate oxide film. Therefore, it is likely that impurity ions such as $Na^+$ either attached to the channel surface during or after washing or are incorporated into the oxide film during the thermal oxidation step. This is one of the significant factors for deterioration of the interface condition between the channel and the gate oxide film or the quality of the oxide film.

The present invention seeks to provide a semi-conductor crystal growth apparatus for forming a semi-conductor device, which apparatus can cause growth of an epitaxial layer having excellent crystallinity and a gate insulating film having extremely good interface properties, with high mass producibility.

According to the present invention, there is provided an apparatus for producing an insulated gate field effect transistor comprising: preparation chamber means for inserting a substrate into and out of the apparatus, the preparation chamber means including first exhaust means for exhausting the prepartion chamber means, cleaning chamber means for cleaning a surface of the substrate, the cleaning chamber means including a first heating means for heating the substrate and a second exhaust means for exhuasting the cleaning chamber means, a first gate valve communicating the preparation chamber means with the cleaning chamber means so as to transfer the substrate from one to the other, a growth chamber means for forming an epitaxial layer on the cleaned substrate, and a second gate valve communicating the cleaning chamber means with the growth chamber means so as to transfer the substrate from one to the other, characterised by the growth chamber means comprising second heating means for heating the substrate, third exhaust means for evacuating the growth chamber means, and nozzle means for introducing process gases used for forming an epitaxial growth layer and an insulating layer on the substrate into the growth chamber means from outside the growth chamber means, and by a third gate valve communicating the growth chamber means with the preparation chamber means so as to transfer the substrate from one to the other.

Said first exhaust means may exhaust the preparation chamber means to a vacuum of $1 \times 10^{-5}$ Pa or below.

Said second exhaust means may exhaust the cleaning chamber means to a vacuum of $1 \times 10^{-6}$ Pa or below.

Said third exhaust means may exhaust the growth chamber means to a vacuum of $1 \times 10^{-5}$ Pa or below.

In one embodiment said growth chamber means comprises valve means provided between the nozzle means and sources of the gases, and control means for controlling the opening and closing of the valve means according to a predetermined number of cycles of valve opening and closing and a predetermined time of valve opening and closing, whereby the epitaxial growth layer and the insulating layer to be deposited on the epitaxial growth layer are formed consecutively inside the same growth chamber means. Thus the thickness of each of the epitaxial growth layer and the insulating layer may be formed on the substrate with precision level of the order of a mono-atomic layer.

The invention is illustrated, merely by way of example, in the accompanying drawings, in which:-

Figure 1 is a diagrammatic view of a conventional semi-conductor growth apparatus;

Figure 2 is a diagram illustrating change of vacuum with time in a vacuum vessel (cleaning chamber and growth chamber) of the apparatus of Figure 1;

Figure 3 is a sectional view showing the steps of formation of an epitaxial layer and a gate oxide film in a known fabrication process of a MOSFET;

Figure 4 is a diagrammatic view of one embodiment of a semi-conductor crystal growth apparatus according to the present invention;

Figure 5 is a diagram illustrating change of vacuum with time in a cleaning chamber and a growth chamber of the apparatus of Figure 4;

Figure 6 is a diagrammatic view of a growth chamber of a crystal growth apparatus according to the present invention; and

Figure 7 is a sectional view of a MOSFET fabricated using a crystal growth apparatus according to the present invention.

The present invention provides a cleaning chamber in addition to the growth chamber 103 and a preparation chamber 101, so that surface cleaning can be accomplished with high reproducibility and at the same time, a single crystal thin film having excellent crystallinity can be formed.

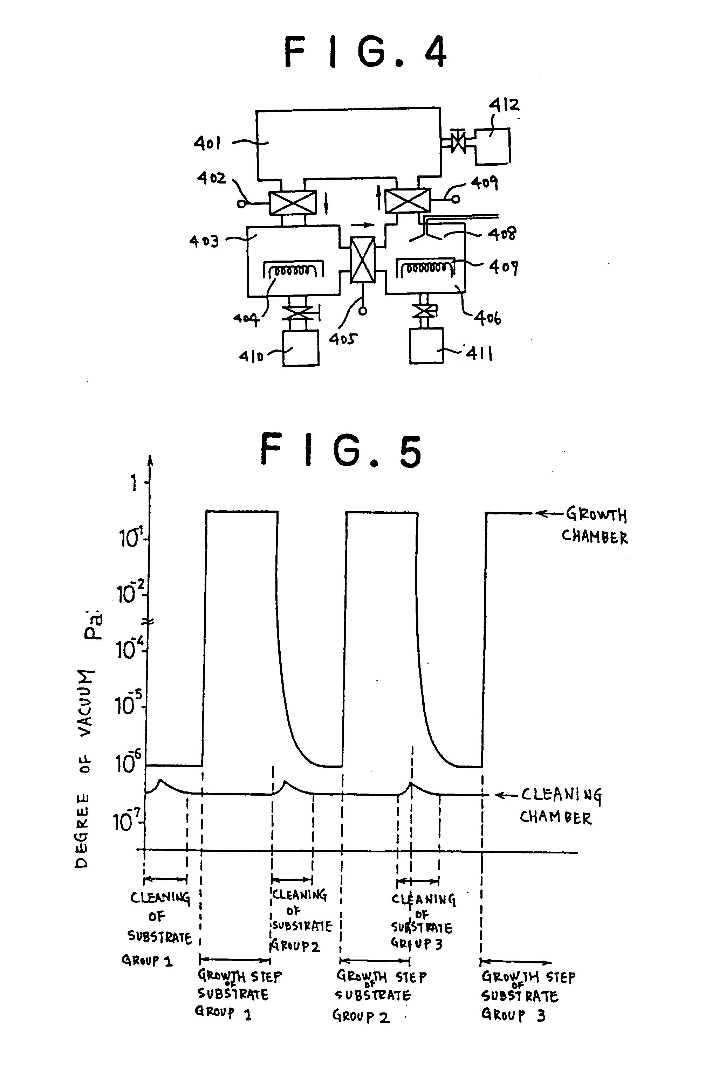

Figure 4 is a diagrammatic view of one embodiment of a semi-conductor crystal growth apparatus according to the present invention. The apparatus has a preparation chamber 401 for inserting a substrate into and out of the apparatus, a gate valve 402, a cleaning chamber 403 for cleaning a surface of the substrate, a heater 404 for heating the substrate, a gate valve 405, a growth chamber 406, a heater 407 for heating the substrate in the growth chamber, a nozzle 408 for introducing process gases and the like into the growth chamber, a gate valve 409 and exhaust systems 410, 411, 412 for evacuating the cleaning chamber, the growth chamber and the preparation chamber to high vacuum, respectively.

The preparation chamber 401 is equipped with the exhaust system 412 capable of attaining a vacuum of $1 \times 10^{-5}$ Pa or below. The cleaning chamber 403 is equipped at least with the heater 404 for heating the substrate and with the exhaust system 410 capable of attaining a vacuum of $1 \times 10^{-6}$ Pa or below, and the growth chamber 406 is equipped at least with the nozzle 408 for introducing gases onto the substrate, the heater 409 for heating the substrate and the exhaust system 411 capable of attaining a vacuum of $1 \times 10^{-5}$ Pa or below.

In the apparatus described above, a single crystal of a semiconductor material such as silicon may be grown by an epitaxial growth method on a substrate at a low temperature in the following manner. The gate valve 402 is opened and the substrate is inserted into the cleaning chamber 403 from the preparation chamber 401. The gate valve 402 is then closed. The substrate surface is cleaned by maintaining, for a predetermined period, the substrate at a temperature of 850°C or above and applying a vacuum of $1 \times 10^{-6}$ Pa, for example (see Figure 5).

Next, the substrate is sent from the cleaning chamber 403 into the growth chamber 406 by opening the gate valve 405 and thereafter the gate valve 405 is closed. Epitaxial growth is carried out for a predetermined period under the conditions that the substrate temperature is from 500 to 800°C, the pressure inside the growth chamber 406 is up to $1 \times 10^{-6}$ Pa, the pressure inside the growth chamber 406 at the time of introduction of process gases is from $1 \times 10^{-3}$ to $1 \times 10^{2}$ Pa and the process gases, as well as a gas reactive with the former, are introduced either simultaneously or alternately. After the epitaxial growth is completed, the gate valve 409 is opened and the substrate is transferred from the growth chamber 406 to the preparation chamber 401. Then, the gate valve 409 is closed. An epitaxial layer having excellent crystallinity can be grown at a low temperature with high reproducibility by repeating the above series of operations.

In a mass production process, at least two substrates are introduced as one group into each of the preparation chamber 401, the cleaning chamber 403 and the growth chamber 406, and each group moves inside the apparatus in accordance with the series of operations described above. In this case, since the atmosphere inside the cleaning chamber 403 is not affected by the atmosphere in the growth chamber 406 in which the growth is repeated, the excellent background as shown in Figure 5 can be maintained and the surface cleaning step can be carried out with high reproducibility. Therefore, the occurrence of defects during crystal growth can be reduced and epitaxial growth can be repeated at a low temperature. Thus, the present invention can grow a high quality single crystal thin film at a low temperature with high reproducibility.

As described above, since the present invention employs a crystal growth apparatus wherein a cleaning chamber for cleaning the surface of a substrate is added to the conventional apparatus consisting of a growth chamber and a preparation chamber, the present invention can clean or purify the substrate surface with high reproducibility inside a vacuum vessel free from influences or background after the crystal growth, and can therefore grow an epitaxial growth film having excellent crystallinity. Moreover, the apparatus of the present invention has high mass producibility that has not been accomplished by conventional apparatus.

Particularly, when a MOSFET having an epitaxial layer to form a channel region and a gate oxide film is fabricated, it is preferred to employ apparatus which is equipped with a mechanism for introducing process gases for forming the channel region by epitaxial growth and for forming the gate oxide film by CVD, e.g. an ultra-vacuum exhaust system, so that it is possible to carry out consecutively the epitaxial growth for forming the channel region and the formation of the gate oxide film inside the same growth chamber under certain operating conditions.

That is, the present embodiment provides an apparatus which grows a first epitaxial growth layer on a semiconductor substrate to form the channel region of a MOSFET and then switches at least one kind of gas among those gases which are used for the growth of the epitaxial growth layer to a gas containing a component element of the insulating film, so that the insulating film can be formed on the epitaxial growth layer in succession to the epitaxial growth layer.

In the present embodiment, the growth chamber 406 comprises the heater 407 for heating the substrate, evacuating system 411 for evacuating the growth chamber to a vacuum of $1 \times 10^{-6}$ Pa or below, the nozzle 408 for introducing gases used for forming the epitaxial layer and the gate oxide film on the substrate into the growth chamber from outside, valve means (not shown) provided between the nozzle means and sources of the gases and a control device (not shown) for controlling the opening and closing of the valve means according to a predetermined number of cycles and timings of opening and closing. According to the present embodiment, since the channel formation step and the gate oxide film formation step can be united into one consecutive step in a clean atmosphere, a gate oxide film having extremely good interface condition can be formed substantially simultaneously with the channel region having excellent crystallinity. The present embodiment can also contribute to the simplification of the fabrication process.

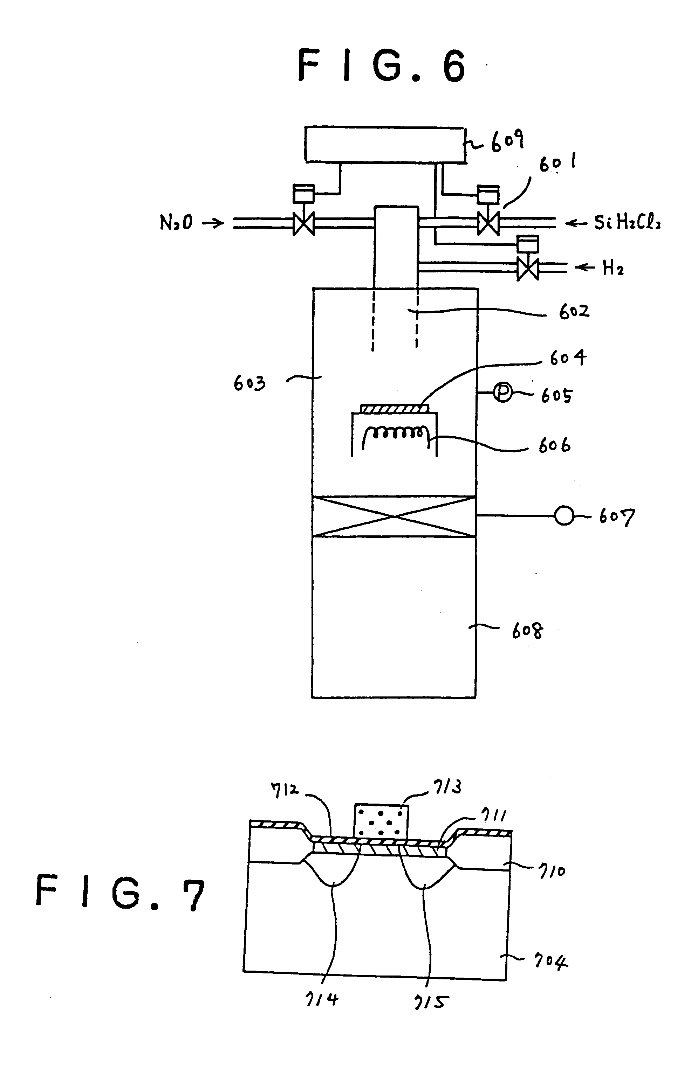

Figure 6 shows a growth chamber 603 of a crystal growth apparatus according to the present invention. Gases used for forming an epitaxial layer and an insulating film are supplied through a valve 601 and a nozzle 602 onto a surface 604 which is set on a heater 606 inside the growth chamber 603. The growth chamber 603 is evacuated by an exhaust system 608 through a gate valve 607 and the vacuum inside the growth chamber 603, when the gases are not introduced, is below $1 \times 10^{-6}$ Pa. The pressure inside the growth chamber 603 is measured by a pressure gauge 605. The opening and closing operations of the valve 601 are controlled by a controller 609.

An epitaxial growth layer (channel region) 711 and a gate oxide film 712 of a MOSFET shown in Figure 7 are formed consecutively in the following manner. First, in order to form the channel region by epitaxial growth, the gate valve 402 is opened and the substrate 604 is put into the cleaning chamber 403 from the preparation chamber 401 of the apparatus shown in Figure 4. The gate valve 402 is then closed. The substrate is heated to about 850°C by the heater 404 and the substrate surface is cleaned. Next, the substrate is sent from the cleaning chamber 403 into the growth chamber 406. The detailed construction of the growth chamber is shown in Figure 6. In the growth chamber 603, the substrate temperature is set to 800°C and the epitaxial growth is started.

The gases used in this case are dichlorosilane ($SiH_2Cl_2$) and hydrogen ($H_2$), for example and

these gases are introduced for a predetermined period within such a range that the pressure inside the growth chamber 603 is from 10 to $1 \times 10^{-3}$ Pa. As the epitaxial growth proceeds, dichlorosilane and hydrogen are introduced either simultaneously or alternately under certain predetermined operation conditions.

Immediately after a single crystal having a desired film thickness has been grown, the introduction of hydrogen among the gases is used for the epitaxial growth is stopped and nitrous oxide ($N_2O$) is introduced instead and formation of the gate oxide film 712 is then started by use of dichlorosilane and nitrous oxide. In this case, dichlorosilane and nitrous oxide are supplied to the surface of the substrate 604 at the same substrate temperature and the same gas introduction pressure and under the same operating conditions as those used for the epitaxial growth step for forming the channel, and an insulating film having a desired film thickness can be deposited onto the epitaxial growth layer 711. The gate oxide film thus formed has an extremely low interface charge density and has an excellent dielectric strength distribution.

After the gate oxide film 712 is deposited in the manner described above, source, drain and gate electrodes 714, 715, 713 repectively are formed to constitute the MOSFET.

In accordance with the formation process of the gate oxide film in the present embodiment, a washing step before the film growth which has been indispensable conventionally becomes entirely unnecessary and various problems that might otherwise occur with washing do not occur. Therefore, since the gate oxide film having ideal interface characteristics can be formed on the channel having excellent crystallinity, the present invention can improve the performance of switching devices and memory devices based on an MOS structure.

## Claims

1. Apparatus for producing an insulated gate field effect transistor comprising: preparation chamber means (401) for inserting a substrate into and out of the apparatus, the preparation chamber means including first exhaust means (412) for exhausting the prepartion chamber means (401), cleaning chamber means (403) for cleaning a surface of the substrate, the cleaning chamber means including a first heating means (404) for heating the substrate and a second exhaust means (410) for exhuasting the cleaning chamber means, a first gate valve (402) communicating the preparation chamber means (401) with the cleaning chamber means (403) so as to transfer the substrate from one to the other, a growth chamber means (406) for forming an epitaxial layer on the cleaned substrate, and a second gate valve (405) communicating the cleaning chamber means (403) with the growth chamber means (406) so as to transfer the substrate from one to the other, characterised by the growth chamber means (406) comprising second heating means (407) for heating the substrate, third exhaust means (411) for evacuating the growth chamber means, and nozzle means (408) for introducing process gases used for forming an epitaxial growth layer and an insulating layer on the substrate into the growth chamber means from outside the growth chamber means, and by a third gate valve (409) communicating the growth chamber means (406) with the preparation chamber means (401) so as to transfer the substrate from one to the other.

2. Apparatus as claimed in claim 1 characterised in that the first exhaust means (412) are arranged for exhausting the preparation chamber means to a vacuum of $1 \times 10^{-5}$ Pa or below.

3. Apparatus as claimed in claim 1 or claim 2 characterised in that the second exhaust means (410) are arranged for exhausting the cleaning chamber means to a vacuum of $1 \times 10^{-5}$ Pa or below.

4. Apparatus as claimed in any preceding claim characterised in that the third exhaust means (411, 608) are arranged for exhausting the growth chamber means to a vacuum of $1 \times 10^{-5}$ Pa or below.

5. Apparatus as claimed in any preceding claim characterised in that said growth chamber means (603) comprises valve means (601) provided between the nozzle means (602) and sources of the gases, and control means for controlling the opening and closing of the valve means according to a predetermined number of cycles of valve opening and closing and a predetermined time of valve opening and closing, whereby the epitaxial growth layer and the insulating layer to be deposited on the epitaxial growth layer are formed consecutively inside the same growth chamber means.

6. Apparatus as claimed in claim 5 characterised in that the control means are arranged to control the opening and closing of the valve means such that each of the epitaxial growth layer and the insulating layer may be formed with precision level on the substrate to a thickness of the order of a mono-atomic layer.

## Revendications

1. Appareil pour la fabrication d'un transistor à effet de champ à grille isolée comprenant : une chambre de préparation (401) prévue pour introduire un substrat dans l'appareil et pour extraire le substrat de l'appareil, la chambre de préparation comprenant des premiers moyens d'évacuation (412) prévus pour faire le vide dans la chambre de préparation (401), une chambre de nettoyage (403) pour nettoyer une surface du substrat, la chambre de nettoyage comprenant des premiers moyens de chauffage (404) prévus pour chauffer le substrat, et des seconds moyens d'évacuation (410) prévus pour faire le vide dans la chambre de nettoyage, un premier sas (402) qui fait communiquer la chambre de préparation (401) avec la chambre de nettoyage (403) de façon à permettre le transfert du substrat de l'une vers l'autre, une chambre de croissance (406) qui est prévue pour la formation d'une couche épitaxiale sur le substrat nettoyé, et un second sas (405) qui fait communiquer la chambre de nettoyage (403) avec la chambre de croissance (406) de façon à permettre le transfet du substrat de l'une vers l'autre, caractérisé en ce que la chambre de croissance (406) comprend des seconds moyens de chauffage (407) pour chauffer le substrat, des troisièmes moyens d'évacuation (411) pour faire le vide dans la chambre de croissance, et une structure de diffuseur (408) pour introduire dans la chambre de croissance, à partir de l'extérieur de celle-ci, des gaz de traitement que l'on utilise pour former une couche de croissance épitaxiale et une couche isolante sur le substrat, et en ce qu'un troisième sas (409) fait communiquer la chambre de croissance (406) avec la chambre de préparation (401), de façon à permettre le transfert du substrat de l'une vers l'autre.

2. Appareil selon la revendication 1, caractérisé en ce que les premiers moyens d'évacuation (412) sont conçus pour faire le vide dans la chambre de préparation jusqu'à un niveau de $1 \times 10^{-5}$ Pa ou moins.

3. Appareil selon la revendication 1 ou la revendication 2, caractérisé en ce que les seconds moyens d'évacuation (410) sont conçus pour faire le vide dans la chambre de nettoyage jusqu'à un niveau de $1 \times 10^{-6}$ Pa ou moins.

4. Appareil selon l'une quelconque des revendications précédentes, caractérisé en ce que les troisièmes moyens d'évacuation (411, 608) sont conçus pour faire le vide dans la chambre de croissance jusqu'à un niveau de $1 \times 10^{-5}$ Pa ou moins.

5. Appareil selon l'une quelconque des revendications précédentes, caractérisé en ce que la chambre de croissance (603) comprend une structure de vannes (601) placée entre la structure de diffuseur (602) et des sources de gaz, et des moyens de commande qui sont destinés à commander l'ouverture et la fermeture de la structure de vannes conformément à un nombre prédéterminé de cycles d'ouverture et de fermeture de vanne, et à des durées prédéterminées d'ouverture et de fermeture de vanne, grâce à quoi la couche de croissance épitaxiale et la couche isolante qui doit être déposée sur la couche de croissance épitaxiale sont formées consécutivement dans la même chambre de croissance.

6. Appareil selon la revendication 5, caractérisé en ce que les moyens de commande sont conçus pour commander l'ouverture et la fermeture de la structure de vannes de façon que chaque couche comprenant la couche de croissance épitaxiale et la couche isolante puisse être formée sur le substrat avec un niveau de précision correspondant à une épaisseur de l'ordre d'une couche monoatomique.

## Patentansprüche

1. Vorrichtung zur Herstellung eines Feldeffekttransistors mit isoliertem Gate mit einer eine erste Abpumpeinrichtung (412) zum Auspumpen der Vorrichtung enthaltenden Vorbereitungskammer (401) zum Einführen und Entnehmen eines Substrats in die bzw. aus der Vorrichtung, einer eine erste Heizeinrichtung (404) zur Erwärmung des Substrats sowie eine zweite Abpumpeinrichtung (410) zu ihrem Auspumpen enthaltenden Reinigungskammer (403) zur Reinigung einer Oberfläche des Substrats, einem ersten Durchlaßschieber (402) zur Verbindung der Vorbereitungskammer (401) mit der Reinigungskammer (403) für die Überführung des Substrats von einer dieser Kammern in die andere, einer Epitaxiekammer (406) zur Bildung einer epitaktischen Schicht auf dem gereinigten Substrat und mit einem zweiten Durchlaßschieber (405) zur Verbindung der Reinigungskammer (403) mit der Epitaxiekammer (406) für die Überführung des Substrats von einer dieser Kammern in die andere, **dadurch gekennzeichnet,** daß die Epitaxiekammer (406) eine zweite Heizeinrichtung (407) zur Erwärmung des Substrats, eine dritte Abpumpeinrichtung (411) zu ihrer Evakuierung und eine Düseneinrichtung (408) zur Einleitung von bei der Erzeung einer epitaktischen Aufwachsschicht und einer Isolatorschicht auf dem Substrat verwendeten Prozeßgasen von außen in sie umfaßt und daß ein dritter Durchlaßschieber (409) zur Verbindung der Epitaxiekammer (406) mit der Vorbereitungskammer (401) für die Überführung des Substrats von einer dieser Kammern in die andere vorgesehen ist.

2. Vorrichtung nach Anspruch 1, **dadurch gekennzeichnet,** daß die erste Abpumpeinrichtung (412) zum Auspumpen der Vorbereitungskammer auf ein Vakuum von $1 \times 10^{-5}$ Pa oder darunter ausgelegt ist.

3. Vorrichtung nach Anspruch 1 oder 2, **dadurch gekennzeichnet,** daß die zweite Abpumpeinrichtung (410) zum Auspumpen der Reinigungskammer auf ein Vakuum von $1 \times 10^{-6}$ Pa oder darunter ausgelegt ist.

4. Vorrichtung nach den vorhergehenden Ansprüchen, **dadurch gekennzeichnet,** daß die dritte Abpumpeinrichtung (411, 608) zum Auspumpen der Epitaxiekammer auf ein Vakuum von $1 \times 10^{-5}$ Pa oder darunter ausgelegt ist.

5. Vorrichtung nach den vorhergehenden Ansprüchen, **dadurch gekennzeichnet,** daß die Epitaxiekammer (603) eine zwischen der Düseneinrichtung (602) und Gasquellen vorgesehene Ventileinrichtung (601) sowie eine Steuereinrichtung zur Steuerung des Öffnens und Schließens der Ventileinrichtung gemäß einer vorgegebenen Anzahl von Ventilöffnungs- und Schließzyklen und einer vorgegebenen Ventilöffnungs- und Schließzeit umfaßt, wodurch die epitaktisch aufgewachsene Schicht und die auf dieser abgeschiedene Isolatorschicht in der gleichen Epitaxiekammer aufeinanderfolgend herstellbar sind.

6. Vorrichtung nach Anspruch 5, **dadurch gekennzeichnet,** daß die Steuereinrichtung für eine derartige Steuerung des Öffnens und Schließens der Ventileinrichtung ausgelegt ist, daß sowohl die epitaktisch aufgewachsene Schicht als auch die Isolatorschicht auf dem Substrat mit einer Dickengenauigkeit in der Größenordnung einer einatomigen Schicht herstellbar sind.

101

102

107

105

104

103

106

# F I G. 2

DEGREE OF VACUUM (Pa)

$1$

$10^1$

$10^2$

$10^4$

$10^5$

$10^6$

$10^7$

CLEANING
OF
SUBSTRATE
GROUP 1

GROWTH STEP
OF
SUBSTRATE
GROUP 1

CLEANING
OF
SUBSTRATE
GROUP 2

GROWTH STEP
OF
SUBSTRATE
GROUP 2

F I G. 3A

303
302
301

↓

CHEMICAL WASHING

↓

F I G. 3B

304
302
301

F I G. 3

# FIG. 4

# FIG. 5

# F I G. 6

N₂O →

→ Si H₂Cl₂

← H₂

609
601
602
603
604
605
606
607
608

# F I G. 7

712
713
711
710
704
714
715